# EUROPÄISCHE PATENTSCHRIFT

(11) **EP 3 011 121 B1**
(45) Veröffentlichungstag und Bekanntmachung des Hinweises auf die Patenterteilung: **09.08.2017**
(21) Anmeldenummer: 14731953.7
(22) Anmeldetag: 20.06.2014
(51) Int. Cl.: E05B 81/64, H01H 47/00, E05B 81/54, E05B 81/72, B60R 16/023, E05B 81/66, E05B 15/04, E05B 81/04, E05B 77/54, E05B 81/62, G01D 5/16, G01R 27/02, B60J 5/00

(54) **ERFASSUNGSEINRICHTUNG FÜR DIE ERFASSUNG VON MECHANISCHEN FUNKTIONSZUSTÄNDEN EINES KRAFTFAHRZEUGSCHLOSSES**
DETECTION DEVICE FOR DETECTING MECHANICAL FUNCTIONAL STATES OF A MOTOR VEHICLE LOCK
SYSTÈME DE DÉTECTION D'ÉTATS FONCTIONNELS MÉCANIQUES D'UNE SERRURE DE VÉHICULE AUTOMOBILE

(30) Priorität: 19.06.2013 DE 102013106398
(43) Veröffentlichungstag der Anmeldung: 27.04.2016
(73) Patentinhaber: Brose Fahrzeugteile GmbH & Co. Kommanditgesellschaft, Bamberg, 96052 Bamberg (DE)
(72) Erfinder: LAPOK, Paul, 42279 Wuppertal (DE); REINERT, Jörg, 42899 Remscheid (DE); EL-HAMOUMI, Abdelali, 42369 Wuppertal (DE)
(74) Vertreter: Gottschald, Jan
(86) Internationale Anmeldenummer: PCT/EP2014/062984
(87) Internationale Veröffentlichungsnummer: WO 2014/202742

(56) Entgegenhaltungen:
- EP-A2- 2 333 208
- US-A1- 2006 213 242

## Beschreibung

Die Erfindung betrifft eine Erfassungseinrichtung für die Erfassung von mechanischen Funktionszuständen eines Kraftfahrzeugschlosses gemäß dem Oberbegriff von Anspruch 1, ein Kraftfahrzeugschloss mit einer solchen Erfassungseinrichtung gemäß Anspruch 11 sowie ein Verfahren zur Erfassung des mechanischen Funktionszustands eines Kraftfahrzeugschlosses mittels einer solchen Erfassungseinrichtung nach Anspruch 15.

Das in Rede stehende Kraftfahrzeugschloss findet Anwendung bei allen Arten von Verschlusselementen eines Kraftfahrzeugs. Dazu gehören insbesondere Seitentüren, Hecktüren, Heckklappen, Heckdeckel oder Motorhauben. Diese Verschlusselemente können grundsätzlich auch nach Art von Schiebetüren ausgestaltet sein.

Ein obiges Kraftfahrzeugschloss weist eine ganze Reihe verstellbarer Funktionselemente auf, die je nach Funktionszustand des Kraftfahrzeugschlosses unterschiedliche Stellungen einnehmen.

Bei dem mechanischen Funktionszustand eines Kraftfahrzeugschlosses kann es sich beispielsweise um einen Verriegelungszustand wie "verriegelt" oder "entriegelt" handeln. Je nach Verriegelungszustand des Kraftfahrzeugschlosses lässt sich das zugeordnete Verschlusselement durch eine Betätigung eines Türaußengriffs und/oder eines Türinnengriffs öffnen. Der Funktionszustand eines Kraftfahrzeugschlosses umfasst aber auch den Schließzustand des Kraftfahrzeugschlosses. Für den üblichen Fall, dass das Kraftfahrzeugschloss eine Schlossfalle aufweist, die bei einer Schließbewegung des Verschlusselements in Eingriff mit einem karosseriefesten Schließkeil o. dgl. kommt, umfasst der Schließzustand beispielsweise die Stellung der Schlossfalle. Für den Fall, dass der Schlossfalle eine Sperrklinke zugeordnet ist, welche die Schlossfalle in einer Schließstellung sperrt, umfasst der Schließzustand auch die Stellung der Sperrklinke.

Der Funktionszustand eines Kraftfahrzeugschlosses kann neben dem Verriegelungszustand und dem Schließzustand auch andere Zustände umfassen, auf die im Einzelnen nicht weiter eingegangen wird.

Zur Erfassung mechanischer Funktionszustände eines Kraftfahrzeugschlosses ist regelmäßig eine Erfassungseinrichtung vorgesehen. Die bekannte Erfassungseinrichtung (EP 2 333 208 A2), von der die Erfindung ausgeht, ist mit einer Sensoranordnung aus zwei Sensorschaltern ausgestattet, welche die Stellung zweier Funktionselemente, hier der Schlossfalle und der Sperrklinke, erfassen. Die Erfassungseinrichtung weist zwei binäre Signalausgänge auf, zu denen in Abhängigkeit von dem Funktionszustand, hier vom Schließzustand des Kraftfahrzeugschlosses, ein Referenzpotential durchgeschaltet wird. Aus dem logischen Zustand der Signalausgänge wird mittels einer Steuerungsanordnung der resultierende Funktionszustand des Kraftfahrzeugschlosses ermittelt.

Mit der bekannten Erfassungseinrichtung ist eine besonders fehlerrobuste Erfassung von Funktionszuständen des Kraftfahrzeugschlosses möglich. Optimierungspotential besteht im Hinblick auf die Steigerung der Anzahl erfassbarer Funktionszustände mit einer möglichst geringen Anzahl binärer Signalausgänge.

Der Erfindung liegt daher das Problem zu Grunde, die bekannte Erfassungseinrichtung derart auszugestalten und weiterzubilden, dass die Anzahl der erfassbaren Funktionszustände bei einer vorgegebenen Anzahl von binären Signalausgängen erhöht wird.

Das obige Problem wird bei einer Erfassungseinrichtung gemäß dem Oberbegriff von Anspruch 1 durch die Merkmale des kennzeichnenden Teils von Anspruch 1 gelöst.

Wesentlich ist die grundsätzliche Überlegung, dass nicht nur der logische Zustand von Signalausgängen, sondern auch der elektrische Widerstand zwischen Signalausgängen bei geeigneter Auslegung der Erfassungseinrichtung einen gewissen Informationsgehalt aufweisen kann.

Es wird zunächst vorgeschlagen, dass im montierten Zustand mindestens zwei Funktionszustände des Kraftfahrzeugschlosses ein und denselben logischen Zustand der Erfassungseinrichtung erzeugen, welcher logische Zustand im Folgenden als "Mehrfachzustand" bezeichnet wird.

Wesentlich ist, dass die Funktionszustände, die zu ein und demselben logischen Zustand der Erfassungseinrichtung führen, dadurch unterscheidbar sind, dass der elektrische Wiederstand zwischen zwei vorbestimmten Signalausgängen der Erfassungseinrichtung in Abhängigkeit von dem jeweiligen Funktionszustand unterschiedlich ist. Um dies auszunutzen, wird weiter vorgeschlagen, dass die Steuerungsanordnung den Funktionszustand des Kraftfahrzeugschlosses nicht nur basierend auf dem logischen Zustand der Signalausgänge, sondern auch basierend auf dem elektrischen Wiederstand zwischen vorbestimmten Signalausgängen ermittelt.

Durch den zusätzlichen, auf den elektrischen Widerstand zwischen den vorbestimmten Signalausgängen zurückgehenden Informationsgehalt lässt sich die Anzahl erfassbarer mechanischer Funktionszustände erhöhen, ohne dass damit eine Komplexitätssteigerung der Erfassungseinrichtung verbunden ist.

Beispielsweise ist es gemäß Anspruch 3 vorgesehen, dass die Erfassungseinrichtung genau zwei Signalausgänge aufweist, wobei genau ein Mehrfachzustand vorgesehen ist. Der Mehrfachzustand korrespondiert zu einem Funktionszustand des Kraftfahrzeugschlosses mit einem ersten Widerstandswert zwischen den beiden Signalausgängen und zu einem anderen Funktionszustand des Kraftfahrzeugschlosses mit einem zweiten Widerstandswert zwischen den beiden Signalausgängen. Insgesamt lassen sich mit den beiden, binären Signalausgängen insgesamt fünf Funktionszustände des Kraftfahrzeugschlosses abbilden.

Eine vorschlagsgemäße Erfassungseinrichtung lässt sich mit ganz unterschiedlichen Schaltungsanordnungen umsetzen. Bei den bevorzugten Ausgestaltungen gemäß den Ansprüchen 7 und 8 ist die Erfassungseinrichtung mit einer Sensoranordnung mit mindestens zwei Sensorschaltern ausgestaltet. Hiermit ist eine besonders kostengünstige Anordnung denkbar, insbesondere wenn es sich bei den Sensorschaltern um einfache Mikroschalter o. dgl. handelt.

Vorteilhaft kann die Erfassungseinrichtung auch eine Sensoranordnung gemäß den Ansprüchen 9 und 10 aufweisen, die als Schleifringanordnung ausgestaltet ist. Eine solche Erfassungseinrichtung lässt sich in ganz besonders kompakter Weise ausgestalten.

Nach einer weiteren Lehre gemäß Anspruch 11, der eigenständige Bedeutung zukommt, wird ein Kraftfahrzeugschloss mit einer Schlossmechanik, die in verschiedene Funktionszustände bringbar ist, und mit einer vorschlagsgemäßen Erfassungseinrichtung beansprucht. Auf alle Ausführungen zu der vorschlagsgemäßen Erfassungseinrichtung darf verwiesen werden.

Nach einer weiteren Lehre gemäß Anspruch 15, der ebenfalls eigenständige Bedeutung zukommt, wird ein Verfahren zur Erfassung von mechanischen Funktionszuständen eines Kraftfahrzeugschlosses mittels einer Erfassungseinrichtung beansprucht.

Die für das vorschlagsgemäße Verfahren verwendete Erfassungseinrichtung weist mindestens zwei binäre Signalausgänge auf, die über die jeweils dort anliegenden elektrischen Potentiale einen logischen Zustand definieren, wobei jeder Funktionszustand des Kraftfahrzeugschlosses, wie oben angesprochen, einen logischen Erfassungszustand der Erfassungseinrichtung erzeugt.

Wesentlich nach dieser weiteren Lehre ist, dass der Funktionszustand des Kraftfahrzeugschlosses basierend auf dem logischen Zustand der Signalausgänge und dem elektrischen Widerstand zwischen vorbestimmten Signalausgängen ermittelt wird. Ein solches Verfahren lässt sich jedenfalls mit einer vorschlagsgemäßen Erfassungseinrichtung umsetzen, so dass auch insoweit auf alle Ausführungen zu der vorschlagsgemäßen Erfassungseinrichtung verwiesen werden darf.

Im Folgenden wird die Erfindung anhand einer ein Ausführungsbeispiel darstellenden Zeichnung näher erläutert. In der Zeichnung zeigt
- Fig. 1: eine vorschlagsgemäße Erfassungseinrichtung, die in einem vorschlagsgemäßen Kraftfahrzeugschloss montiert ist,
- Fig. 2: eine Sensoranordnung und eine Steuerungsanordnung der Erfassungseinrichtung gemäß Fig. 1 in einer ersten Ausführungsform,
- Fig. 3: eine Sensoranordnung und eine Steuerungsanordnung der Erfassungseinrichtung gemäß Fig. 1 in einer weiteren Ausführungsform und
- Fig. 4: ein Zustandsdiagramm, das auf die in den Fig. 2 und Fig. 3 dargestellten Sensoranordnungen anwendbar ist.

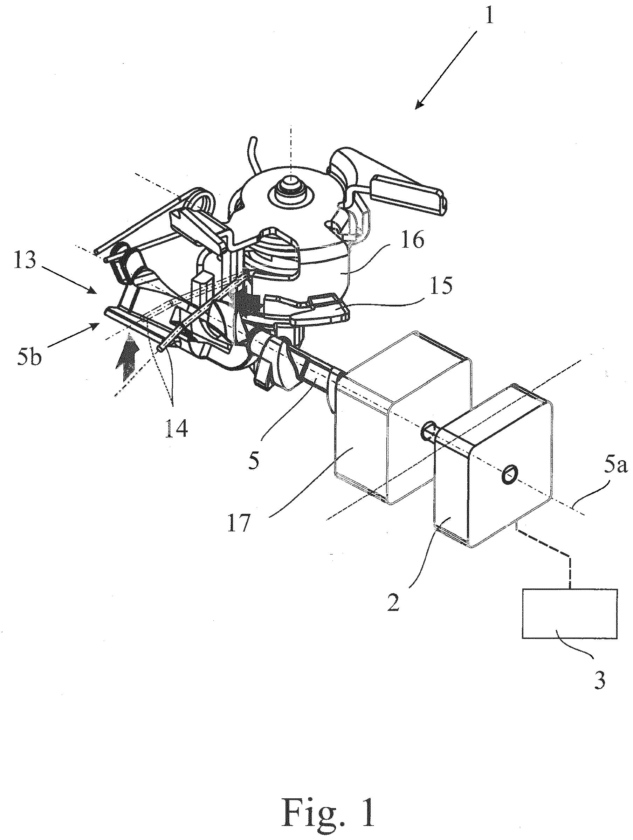

Das in Fig. 1 dargestellte, vorschlagsgemäße Kraftfahrzeugschloss 1 ist mit einer vorschlagsgemäßen Erfassungseinrichtung 2 ausgestattet. Die Erfassungseinrichtung 2 dient der Erfassung von mechanischen Funktionszuständen des Kraftfahrzeugschlosses 1. Ein solches Kraftfahrzeugschloss 1 kann je nach Ausgestaltung verschiedene Funktionszustände einnehmen, wie im einleitenden Teil der Beschreibung erläutert worden ist.

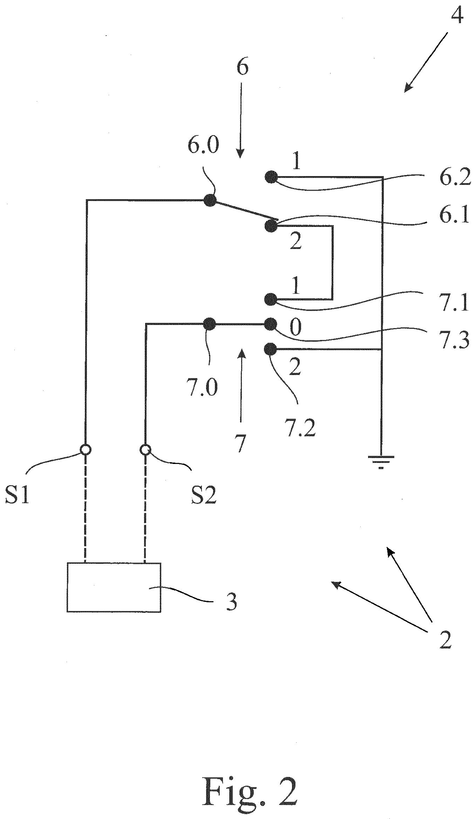

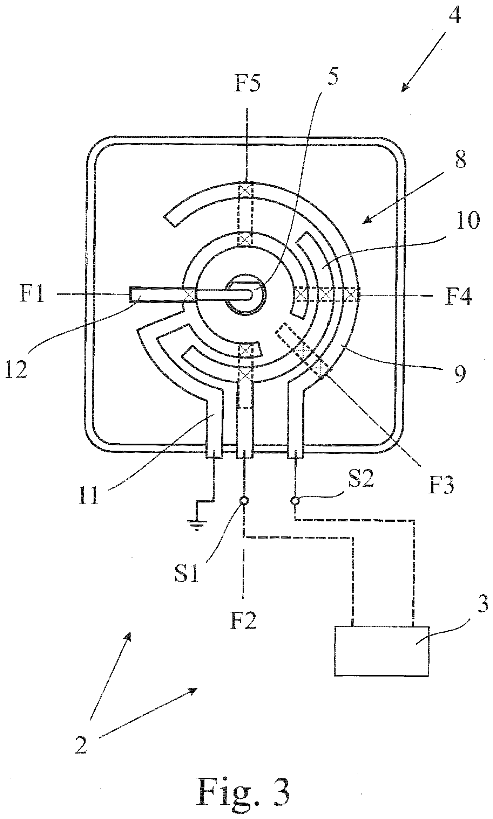

Die Erfassungseinrichtung weist mindestens zwei, hier genau zwei, binäre Signalausgänge S1, S2 auf. Mit "binärer Signalausgang" ist vorliegend gemeint, dass der Signalausgang über das am Signalausgang anliegende, elektrische Potential genau zwei logische Zustände einnehmen kann. Beispielsweise sind die in den Fig. 2, 3 dargestellten Signalausgänge S1, S2 mit Massepotential M verbunden oder von Massepotential M getrennt. Der mit Massepotential M verbundene Zustand entspricht hier dem binären Zustand "1", während der vom Massepotential M getrennte Zustand dem logischen Zustand "0" entspricht. Denkbar ist auch, dass an den Signalausgängen S1, S2 in Abhängigkeit von dem jeweiligen logischen Zustand ein positives Potential oder ein negatives Potential anliegt.

Die Erfassungseinrichtung 2 ist ferner mit einer Steuerungsanordnung 3 ausgestattet, die elektrisch mit den Signalausgängen S1, S2 gekoppelt ist und basierend auf dieser Kopplung den Funktionszustand des Kraftfahrzeugschlosses 1 ermittelt. Die Steuerungsanordnung 3 kann grundsätzlich dem Kraftfahrzeugschloss 1 räumlich zugeordnet sein. Denkbar ist aber auch, dass es sich bei der Steuerungsanordnung um einen Bestandteil einer zentralen Kraftfahrzeugsteuerung o. dgl. handelt.

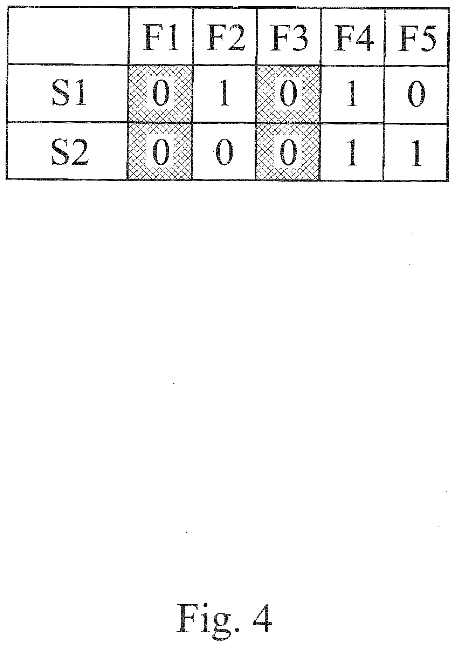

Fig. 4 zeigt ein Zustandsdiagramm, dem der Zusammenhang zwischen fünf Funktionszuständen F1-F5 des Kraftfahrzeugschlosses 1 zu den logischen Zuständen der Signalausgänge S1, S2 entnommen werden kann. Dabei wird deutlich, dass zwei Funktionszustände, nämlich die Funktionszustände F1 und F3, ein und denselben logischen Zustand, nämlich S1: "0" und S2: "0" erzeugen. Dieser logische Zustand wird, wie oben angedeutet, vorliegend als "Mehrfachzustand" bezeichnet.

Wesentlich für die vorschlagsgemäße Lehre ist, dass die einen logischen Mehrfachzustand der Erfassungseinrichtung 2 verursachenden Funktionszustände des Kraftfahrzeugschlosses 1 dadurch unterscheidbar sind, dass der elektrische Widerstand zwischen zwei vorbestimmten Signalausgängen S1, S2 der Erfassungseinrichtung 2 in Abhängigkeit von dem jeweiligen Funktionszustand unterschiedlich ist. Entsprechend ist es vorschlagsgemäß so, dass die Steuerungsanordnung 3 basierend auf dem logischen Zustand der Signalausgänge S1, S2 und dem elektrischen Widerstand zwischen dem vorbestimmten Signalausgängen S1, S2 den Funktionszustand des Kraftfahrzeugschlosses 1 ermittelt. Mit der Berücksichtigung des elektrischen Widerstands zwischen den beiden Signalausgängen S1, S2 lässt sich verglichen mit einer üblichen binären Codierung zweier Signalausgänge ein zusätzlicher Funktionszustand abbilden.

Die Berücksichtigung des elektrischen Widerstands zwischen den Signalausgängen S1, S2 kann durch eine Messung eines konkreten Widerstandswertes erfolgen. Hier und vorzugsweise ist es allerdings so, dass die Signalausgänge S1, S2 lediglich daraufhin überprüft werden, ob zwischen ihnen eine elektrisch leitende Verbindung oder keine elektrisch leitende Verbindung besteht. Entsprechend ist es schaltungstechnisch vorzugsweise vorgesehen, dass der elektrische Widerstand zwischen den zwei vorbestimmten Signalausgängen S1, S2 in Abhängigkeit von dem jeweiligen Funktionszustand des Kraftfahrzeugschlosses 1 einer elektrisch leitenden Verbindung entspricht oder aber gegen unendlich geht.

Bei den in den Fig. 2 und 3 dargestellten Ausführungsbeispielen sind genau zwei Signalausgänge S1, S2 und genau ein Mehrfachzustand vorgesehen. Eine Berücksichtigung eines Widerstands kommt entsprechend nur zwischen den Signalausgängen S1, S2 in Frage.

Die vorschlagsgemäße Lösung lässt sich aber auch auf eine Erfassungseinrichtung 2 mit mehr als zwei Signalausgängen anwenden, wobei sich auf einfache schaltungstechnische Weise mindestens zwei Mehrfachzustände mit den damit einhergehenden, zusätzlich erfassbaren Funktionszuständen des Kraftfahrzeugschlosses 1 realisieren lassen.

Die vorschlagsgemäße Erfassungseinrichtung 2 ist mit einer Sensoranordnung 4 ausgestattet, die die Signalausgänge S1, S2 der Erfassungseinrichtung 2 bereitstellt. Der Begriff "Sensoranordnung" ist vorliegend weit zu verstehen und umfasst sowohl komplexe Zustandssensoren mit integrierter Signalauswertung als auch einfache Schalteranordnungen, wie weiter unten erläutert wird.

Eine schaltungstechnisch einfache Anordnung lässt sich dadurch erreichen, dass ein elektrisches Referenzpotential M, hier und vorzugsweise Massepotential M, vorgesehen ist, wobei die Sensoranordnung 4 das Referenzpotential M zur Einstellung eines logischen Zustands zu den Signalausgängen S1, S2 durchschaltet. Im Einzelnen ist es hier und vorzugsweise so, dass die Sensoranordnung 4 das Referenzpotential M in Abhängigkeit von dem aktuellen Funktionszustand des Kraftfahrzeugschlosses 1 zu den Signalausgängen S1, S2 durchschaltet. Denkbar ist aber auch, wie oben erläutert, dass unterschiedliche elektrische Potentiale in Abhängigkeit von dem aktuellen Funktionszustand des Kraftfahrzeugschlosses 1 zu den Signalausgängen S1, S2 durchgeschaltet werden.

Für die Erfassung des Funktionszustands des Kraftfahrzeugschlosses 1 ist die Erfassungseinrichtung 2 im montierten Zustand mindestens einem verstellbaren Funktionselement 5 zugeordnet, das hier und vorzugsweise als Steuerwelle 5 des Kraftfahrzeugschlosses 1 ausgestaltet ist. Wesentlich dabei ist, dass der logische Zustand der Erfassungseinrichtung 2 durch die Stellung des mindestens einen Funktionselements 5 bestimmt wird. Dabei kann, wie in den dargestellten Ausfiihrungsbeispielen, eine mechanische Kopplung zwischen dem Funktionselement 5 und der Erfassungseinrichtung 2 vorgesehen sein. Grundsätzlich ist aber auch eine berührungslose Kopplung denkbar, beispielsweise, wenn die Sensoranordnung 4 Näherungssensoren o. dgl. aufweist.

Die Fig. 2 und 3 zeigen zwei vorteilhafte Varianten für die Ausgestaltung der Sensoranordnung 4 der Erfassungseinrichtung 2, die dem Funktionselement 5 zugeordnet ist.

Fig. 2 zeigt, dass die Sensoranordnung 4 zwei hier und vorzugsweise als Wechselschalter 6, 7 ausgestaltete Sensorschalter aufweist. Um mehr als zwei Signalausgänge S1, S2 zu realisieren, können auch mehr als zwei Sensorschalter vorgesehen sein.

Die Wechselschalter 6, 7 wirken im montierten Zustand mit dem mindestens einen Funktionselement 5 des Kraftfahrzeugschlosses 1 zusammen, wobei deren Schaltzustände durch die Stellung des Funktionselements 5 bestimmt werden. Die Wechselschalter 6, 7 können beispielsweise im Gehäuse der in Fig. 1 dargestellten Erfassungseinrichtung 2 angeordnet sein. Denkbar ist in diesem Zusammenhang, dass das als Steuerwelle ausgestaltete Funktionselement 5 Nocken aufweist, die mit den beiden Wechselschaltern 6, 7 zusammenwirken. Beide Wechselschalter 6, 7 sind mit einem Mittelkontakt 6.0, 7.0 und mit Schaltkontakten 6.1, 6.2, 7.1, 7.2 ausgestattet, wobei der jeweilige Mittelkontakt 6.0, 7.0 je nach Schaltstellung mit den jeweils zugeordneten Schaltkontakten 6.1, 6.2, 7.1, 7.2 verbunden ist. Bei dem in Fig. 2 dargestellten und insoweit bevorzugten Ausführungsbeispiel ist es so, dass die Mittelkontakte 6.0, 7.0 der Wechselschalter 6, 7 jeweils einen Signalausgang S1, S2 bilden, wobei ein erster Schaltkontakt 6.1 des ersten Wechselschalters 6 mit einem ersten Schaltkontakt 7.1 des zweiten Wechselschalters 7 verbunden ist. Mit dieser Verbindung lässt sich der oben angesprochene, elektrische Widerstand zwischen den beiden Schaltkontakten S1, S2 für die Realisierung eines weiteren logischen Zustands durch einen Schaltvorgang verändern.

Weiter vorzugsweise ist ein zweiter Schaltkontakt 6.2 des ersten Wechselschalters 6 und ein zweiter Schalterkontakt 7.2 des zweiten Wechselschalters 7 mit einem Referenzpotential M, hier mit Massepotential M, verbunden. Dadurch ist es möglich, das Referenzpotential M wie oben angesprochen zu den beiden Signalausgängen S1, S2 durchzuschalten.

Die beiden Wechselschalter 6, 7 lassen sich in Abhängigkeit von der Stellung des Funktionselements 5 in zwei Schaltstellungen stellen, in denen der Mittelkontakt 6.0, 7.0 entweder mit dem ersten Schaltkontakt 6.1, 7.1 oder mit dem zweiten Schaltkontakt 6.2, 7.2 verbunden ist.

Bei dem in Fig. 2 dargestellten und insoweit bevorzugten Ausführungsbeispiel ist es ferner so, dass mindestens einer der Wechselschalter 6, 7, hier und vorzugsweise der zweite Wechselschalter 7, eine Mittelstellung aufweist, in der der Mittelkontakt 7.0 mit einem dritten Schaltkontakt 7.3 verbunden ist, wobei, weiter vorzugsweise, der Mittelkontakt 7.0 in der Mittelstellung nicht mit dem Referenzpotential M beaufschlagt ist.

Die möglichen logischen Zustände der Erfassungseinrichtung gemäß Fig. 2 lassen sich dem Zustandsdiagramm gemäß Fig. 4 entnehmen, unter der Maßgabe, dass die Beaufschlagung der Signalausgänge S1, S2 mit Massepotential M dem logischen Zustand "1" entspricht.

Interessant ist der logische Mehrfachzustand S1: "0", S2: "0" der Erfassungseinrichtung 2, der den beiden Funktionszuständen F1 und F3 entspricht. Hier ist der Mittelkontakt 6.0 des ersten Wechselschalters 6 mit dem ersten Schaltkontakt 6.1 verbunden, während der Mittelkontakt 7.0 des zweiten Wechselschalters 7 mit dem ersten Schaltkontakt 7.1 oder dem dritten Schaltkontakt 7.3 verbunden ist. In beiden letztgenannten Fällen ergibt sich der logische Zustand S1: "0", S2: "0". Unterscheidbar sind diese beiden Funktionszustände aber dadurch, dass für den Fall, dass der Mittelkontakt 7.0 mit dem ersten Schaltkontakt 7.1 verbunden ist, die beiden Signalausgänge S1, S2 leitend miteinander verbunden sind und für den Fall, dass der Mittelkontakt 7.0 mit dem dritten Schaltkontakt 7.3 verbunden ist, die beiden Signalausgänge S1, S2 voneinander isoliert sind. Diese Widerstandsänderung zwischen den Signalausgängen S1, S2 wird von der vorschlagsgemäß von der Steuerungsanordnung 3 erfasst und bei der Ermittlung des Funktionszustands des Kraftfahrzeugschlosses 1 berücksichtigt.

Eine bevorzugte konstruktive Variante zu der Sensoranordnung 4 gemäß Fig. 2 ist in Fig. 3 gezeigt. Hier ist die Sensoranordnung 4 als Schleifringanordnung 8 mit elektrisch voneinander getrennt ausgestalteten Schleifbahnen 9, 10, 11 und mit einem relativ zu den Schleifbahnen 9, 10, 11 verstellbaren Schleifkontakt 12 ausgestaltet. Vorzugsweise sind mindestens drei solcher Schleifbahnen 9, 10, 11 vorgesehen. Hier und vorzugsweise weist die Schleifbahnanordnung genau drei elektrisch voneinander getrennt ausgestaltete Schleifbahnen 9, 10, 11 auf.

Der Schleifkontakt 12 ist so ausgestaltet und angeordnet, dass er die Schleifbahnen 9, 10, 11 je nach Stellung des Schleifkontakts 12 elektrisch miteinander verbindet. Dabei ist es hier und vorzugsweise so, dass der Schleifkontakt 12 mit mindestens einem Funktionselement 5, weiter vorzugsweise mit dem als Steuerwelle ausgestalteten Funktionselement 5, zusammenwirkt, wobei die Stellung des Schleifkontakts 12 entsprechend durch die Stellung des Funktionselements 5 bestimmt wird. Umgekehrt kann es auch vorteilhaft sein, dass die Schleifbahnen 9, 10, 11 mit dem Funktionselement 5 zusammenwirken, so dass die Stellung der Schleifbahnen 9, 10, 11 durch die Stellung des Funktionselements 5 bestimmt wird, während der Schleifkontakt 12 feststeht. Die Schleifbahnanordnung 8 ist vorzugsweise im Gehäuse der in Fig. 1 dargestellten Erfassungseinrichtung 2 untergebracht.

Im Sinne einer kompakten Ausgestaltung ist die Schleifbahnanordnung 8 als Schleifringanordnung 8 ausgestaltet, so dass die Schleifbahnen 9, 10, 11 zumindest abschnittsweise entlang einer Kreisbahn verlaufen. In besonders bevorzugter Ausgestaltung ist die hier als Schleifringanordnung ausgestaltete Schleifbahnanordnung 8 konzentrisch auf die Steuerwellenachse 5a des als Steuerwelle ausgestalteten Funktionselements 5 ausgerichtet. Dabei ist der Schleifkontakt 12 vorzugsweise um eine Schwenkachse schwenkbar, die der Steuerelementachse 5a geometrisch entspricht.

Es sind eine ganze Reihe vorteilhafter Möglichkeiten für die elektrische Beschaltung der Schleifbahnanordnung 8 denkbar. Bei dem in Fig. 3 dargestellten und insoweit bevorzugten Ausführungsbeispiel bilden mindestens zwei, hier und vorzugsweise genau zwei, Schleifbahnen 9, 10 jeweils einen Signalausgang S1, S2 der Erfassungseinrichtung 2, während weiter vorzugsweise die hier verbleibende, dritte Schleifbahn 11 mit dem Referenzpotential M, hier und vorzugsweise mit Massepotential M, beaufschlagt ist.

Das Schaltverhalten der in Fig. 3 dargestellten Schleifbahnanordnung 8 ist identisch zu dem Schaltverhalten der in Fig. 2 dargestellten Schaltungsanordnung aus zwei Wechselschaltern 6, 7. Insoweit lässt sich das in Fig. 4 dargestellte Zustandsdiagramm auch auf die in Fig. 3 dargestellte Schleifbahnanordnung 8 anwenden. Interessant ist auch hier der Mehrfachzustand der Erfassungseinrichtung 2, der sich in den Funktionszuständen F1 und F3 des Kraftfahrzeugschlosses einstellt. Es lässt sich der Darstellung gemäß Fig. 3 entnehmen, dass der Schleifkontakt 12 im Funktionszustand F1 ausschließlich mit der Schleifbahn 11, also mit Massepotential M, verbunden ist, während der Schleifkontakt 12 im Funktionszustand F3 mit den beiden Schleifbahnen 9, 10, diese elektrisch verbindend, in Kontakt steht. Damit sind die beiden Signalausgänge S1, S2 im Funktionszustand F1 elektrisch voneinander getrennt und im Funktionszustand F3 elektrisch miteinander verbunden, was wiederum von der Steuerungsanordnung 3 zur Unterscheidung der beiden Funktionszustände F1 und F3 genutzt wird.

Nach einer weiteren Lehre, der eigenständige Bedeutung zukommt, wird das obige Kraftfahrzeugschloss 1 mit einer erfindungsgemäßen Erfassungseinrichtung als solches beansprucht. Es darf in diesem Zusammenhang darauf hingewiesen werden, dass in der Zeichnung nur die Komponenten des vorschlagsgemäßen Kraftfahrzeugschlosses 1 dargestellt sind, die für die Erläuterung der Lehre notwendig sind. Entsprechend ist eine Schlossfalle, die in üblicher Weise mit einem Schließbolzen o. dgl. zusammenwirkt und die mittels einer Sperrklinke in eine Hauptschließstellung und in eine ggf. vorhandenen Vorschließstellung gehalten wird, in der Zeichnung nicht dargestellt.
Das Kraftfahrzeugschloss 1 weist eine Schlossmechanik 13 auf, die in verschiedene Funktionszustände bringbar ist. Der Schlossmechanik 13 kommt in erster Linie eine Kupplungsfunktion zu. Hierfür ist ein vorzugsweise drahtartiges Kupplungselement 14 vorgesehen, das in verschiedene Kupplungsstellungen bringbar ist. In Fig. 1 ist eine Kupplungsstellung in durchgezogener Linie und eine weitere Kupplungsstellung in gestrichelter Linie dargestellt. Die Kupplungsfunktion besteht im Wesentlichen darin, einen Innenbetätigungshebel 15 und einen Außenbetätigungshebel 16 derart mit der Sperrklinke des Kraftfahrzeugschlosses 1 zu koppeln, bzw. von der Sperrklinke des Kraftfahrzeugschlosses 1 zu entkoppeln, dass die Sperrklinke durch eine Betätigung eines der beiden Betätigungshebels 15, 16 in Abhängigkeit des Funktionszustand des Kraftfahrzeugschlosses 1 ausgehoben werden kann.
Das vorschlagsgemäße Kraftfahrzeugschloss 1 ist auch mit einer obigen Erfassungseinrichtung 2 für die Erfassung von mechanischen Funktionszuständen des Kraftfahrzeugschlosses 1 ausgestattet. Insoweit darf auf alle Ausführungen zu der vorschlagsgemäßen Erfassungseinrichtung 2 verwiesen werden. Wie weiter oben erläutert, ist die Erfassungseinrichtung 2 in dem in Fig. 1 dargestellten, montierten Zustand einem verstellbaren Funktionselement 5 des Kraftfahrzeugs 1 zugeordnet, wobei der logische Zustand der Erfassungseinrichtung 2 durch die Stellung des Funktionselements 5 bestimmt wird.

Bei dem in Fig. 1 dargestellten und insoweit bevorzugten Ausführungsbeispiel ist die Schlossmechanik 13 und damit das Kraftfahrzeugschloss 1 in unterschiedliche Funktionszustände wie "verriegelt", "entriegelt", "diebstahlgesichert", "verriegelt-kindergesichert" und "entriegelt-kindergesichert" bringbar, wobei die Einstellung dieser insgesamt fünf Funktionszustände durch eine entsprechende Verstellung des Funktionselements 5 bewerkstelligt werden kann. Interessant ist dabei die Tatsache, dass mit der vorschlagsgemäßen Erfassungseinrichtung 2 eine Erfassung dieser insgesamt fünf Funktionszustände mit nur zwei Signalausgängen S1, S2 möglich ist.

Sofern der Innenbetätigungshebel 15 mit einem Türinnengriff und der Außenbetätigungshebel 16 mit einem Türaußengriff gekoppelt sind, ergeben sich in Abhängigkeit vom Funktionszustand unterschiedliche Möglichkeiten der Öffnung des dem Kraftfahrzeugschloss 1 zugeordneten Verschlusselements, insbesondere der dem Kraftfahrzeugschloss 1 zugeordneten Kraftfahrzeugtür. Im Funktionszustand "verriegelt" kann von innen geöffnet werden, nicht jedoch von außen. Im Funktionszustand "entriegelt" kann sowohl von innen als auch von außen geöffnet werden. Im Funktionszustand "diebstahlgesichert" kann weder von innen noch von außen geöffnet werden. Im Funktionszustand "verriegelt-kindergesichert" kann von innen entriegelt, aber weder von innen noch von außen geöffnet werden. Im Funktionszustand "entriegelt-kindergesichert" kann von außen, aber nicht jedoch von innen geöffnet werden.

Nur zur Klarstellung darf im Hinblick auf das Zustandsdiagramm gemäß Fig. 4 darauf hingewiesen werden, dass F1 dem Funktionszustand "entriegelt", F2 dem Funktionszustand "verriegelt", F3 dem Funktionszustand "diebstahlgesichert", F4 dem Funktionszustand "verriegelt-kindergesichert" und F5 dem Funktionszustand "entriegelt-kindergesichert"` entspricht.

Im Ergebnis lassen sich mit der vorschlagsgemäßen Lösung alle für ein Kraftfahrzeugschloss üblichen Verriegelungszustände mit nur zwei Signalausgängen S1, S2 abbilden. Dies führt zu einer umfassenden Anwendbarkeit der vorschlagegemäßen Erfassungseinrichtung 2 im Bereich der Kraftfahrzeugschlösser.

Insbesondere die in Fig. 3 dargestellte Ausgestaltung der Erfassungseinrichtung 2 mit einer Schleifbahnanordnung 8 lässt sich in besonders kompakter Weise einsetzen, wenn, wie oben erläutert, das betreffende Funktionselement 5 als Steuerwelle ausgestaltet ist. Hier und vorzugsweise ist die Steuerwelle mit einem axialen Steuerabschnitt 5b zum Ausleiten von Steuerbewegungen ausgestaltet, wobei sich das Kupplungselement 14 an dem Steuerabschnitt 5b des Funktionselements 5 abstützt. Grundsätzlich ist es aber auch denkbar, dass die Erfassungseinrichtung 2 einem Funktionselement 5 oder mehreren Funktionselementen 5 zugeordnet ist, das bzw. die hebelartig ausgestaltet ist bzw. sind.

Nach einer weiteren Lehre, der ebenfalls eigenständige Bedeutung zukommt, wird das oben beschriebene Verfahren zur Erfassung von mechanischen Funktionszuständen eines Kraftfahrzeugschlosses 1 mittels einer Erfassungseinrichtung 2 beansprucht.

Die in dem vorschlagsgemäßen Verfahren zur Anwendung gebrachte Erfassungseinrichtung 2 weist mindestens zwei binäre Signalausgänge S1, S2 auf, die über die jeweils dort anliegenden elektrischen Potentiale einen logischen Zustand der Erfassungseinrichtung 2 definieren, wobei jeder Funktionszustand des Kraftfahrzeugschlosses 1 einen logischen Zustand der Erfassungseinrichtung 2 erzeugt.

Wesentlich nach der weiteren Lehre ist, dass der Funktionszustand des Kraftfahrzeugschlosses 1 basierend auf dem logischen Zustand der Signalausgänge S1, S2 und dem elektrischen Widerstand zwischen vorbestimmten Signalausgängen S1, S2 ermittelt wird. In besonders bevorzugter Ausgestaltung kommt hier eine oben erläuterte, vorschlagsgemäße Erfassungseinrichtung 2 zur Anwendung. Auf alle Ausführungen zu der Betriebsweise der vorschlagsgemäßen Erfassungseinrichtung 2 darf verwiesen werden.

## Patentansprüche

1. Erfassungseinrichtung für die Erfassung von mechanischen Funktionszuständen eines Kraftfahrzeugschlosses (1), wobei mindestens zwei binäre Signalausgänge (S1, S2) vorgesehen sind, die über die jeweils dort anliegenden elektrischen Potentiale einen logischen Zustand der Erfassungseinrichtung (2) definieren, wobei im montierten Zustand jeder Funktionszustand des Kraftfahrzeugschlosses (1) einen logischen Zustand der Erfassungseinrichtung (2) erzeugt und wobei eine Steuerungsanordnung (3) vorgesehen ist, die elektrisch mit den Signalausgängen (S1, S2) gekoppelt ist und basierend auf dieser Kopplung den Funktionszustand des Kraftfahrzeugschlosses (1) ermittelt,
**dadurch gekennzeichnet,**
**dass** im montierten Zustand mindestens zwei Funktionszustände des Kraftfahrzeugschlosses (1) ein und denselben logischen Zustand - Mehrfachzustand - der Erfassungseinrichtung (2) erzeugen, dass diese Funktionszustände dadurch unterscheidbar sind, dass der elektrische Widerstand zwischen den vorbestimmten Signalausgängen (S1, S2) der Erfassungseinrichtung (2) in Abhängigkeit von dem jeweiligen Funktionszustand des Kraftfahrzeugschlosses (1) unterschiedlich ist und dass die Steuerungsanordnung (3) basierend auf dem logischen Zustand der Signalausgänge (S1, S2) und dem elektrischen Widerstand zwischen den vorbestimmten Signalausgängen (S1, S2) den Funktionszustand des Kraftfahrzeugschlosses (1) ermittelt.

2. Erfassungseinrichtung nach Anspruch 1, **dadurch gekennzeichnet, dass** der elektrische Widerstand zwischen den zwei vorbestimmten Signalausgängen (S1, S2) in Abhängigkeit von dem jeweiligen Funktionszustand einer elektrisch leitenden Verbindung entspricht oder gegen unendlich geht.

3. Erfassungseinrichtung nach Anspruch 1 oder 2, **dadurch gekennzeichnet, dass** die Erfassungseinrichtung (2) genau zwei Signalausgänge (S1, S2) aufweist und dass genau ein Mehrfachzustand vorgesehen ist, oder, dass die Erfassungseinrichtung (2) mehr als zwei Signalausgänge (S1, S2) aufweist und mindestens zwei Mehrfachzustände vorgesehen sind.

4. Erfassungseinrichtung nach einem der vorhergehenden Ansprüche, **dadurch gekennzeichnet, dass** die Erfassungseinrichtung (2) eine Sensoranordnung (4) aufweist, die die Signalausgänge (S1, S2) der Erfassungseinrichtung (2) bereitstellt.

5. Erfassungseinrichtung nach Anspruch 4, **dadurch gekennzeichnet, dass** ein elektrisches Referenzpotential (M), insbesondere Massepotential (M), vorgesehen ist und dass die Sensoranordnung (4) das Referenzpotential (M) zur Einstellung eines logischen Zustands zu den Signalausgängen (S1, S2) durchschaltet, vorzugsweise, dass die Sensoranordnung (4) im montierten Zustand das Referenzpotential (M) in Abhängigkeit von dem aktuellen Funktionszustand des Kraftfahrzeugschlosses (1) zu den Signalausgängen (S1, S2) durchschaltet.

6. Erfassungseinrichtung nach Anspruch 4 und ggf. nach Anspruch 5, **dadurch gekennzeichnet, dass** die Erfassungseinrichtung (2) im montierten Zustand mindestens einem verstellbaren Funktionselement (5) des Kraftfahrzeugschlosses (1) zugeordnet ist und dass der logische Zustand der Erfassungseinrichtung (2) durch die Stellung des mindestens einen Funktionselements (5) bestimmt wird.

7. Erfassungseinrichtung nach Anspruch 6, **dadurch gekennzeichnet, dass** die Sensoranordnung (4) mindestens zwei Sensorschalter (6, 7), insbesondere Wechselschalter (6, 7), aufweist, die im montierten Zustand mit dem mindestens einen Funktionselement (5) des Kraftfahrzeugschlosses (1) zusammenwirken und deren Schaltzustände durch die Stellung des mindestens einen Funktionselements (5) bestimmt werden.

8. Erfassungseinrichtung nach Anspruch 7, **dadurch gekennzeichnet, dass** die Mittelkontakte (6.0, 7.0) der Wechselschalter (6, 7) jeweils einen Signalausgang (S1, S2) bilden und das ein erster Schaltkontakt (6.1) eines ersten Wechselschalters (6) mit einem ersten Schaltkontakt (7.1) eines zweiten Wechselschalters (7) verbunden ist, vorzugsweise, dass ein zweiter Schaltkontakt (6.2) des ersten Wechselschalters (6) und ein zweiter Schaltkontakt (7.2) des zweiten Wechselschalters (7) mit einem Referenzpotential (M), insbesondere mit Massepotential (M), verbunden ist, vorzugsweise, dass mindestens einer der Wechselschalter (6, 7) eine Mittelstellung aufweist, in der der Mittelkontakt (7.0) mit einem dritten Schaltkontakt (7.3) verbunden ist, weiter vorzugsweise, dass der Mittelkontakt (7.0) in der Mittelstellung nicht mit dem Referenzpotential (M) beaufschlagt ist.

9. Erfassungseinrichtung nach Anspruch 4 und ggf. nach einem der Ansprüche 5 bis 8, **dadurch gekennzeichnet, dass** die Sensoranordnung (4) als Schleifbahnanordnung (8) mit elektrisch voneinander getrennt ausgestalteten Schleifbahnen (9, 10, 11) und mit einem relativ zu den Schleifbahnen (9, 10, 11) verstellbaren Schleifkontakt (12) ausgestaltet ist und dass der Schleifkontakt (12) die Schleifbahnen (9, 10, 11) je nach Stellung elektrisch miteinander verbindet, vorzugsweise, dass der Schleifkontakt (12) oder die Schleifbahnen (9, 10, 11) mit dem mindestens einen Funktionselement (5) des Kraftfahrzeugschlosses (1) zusammenwirkt bzw. zusammenwirken und die Stellung von Schleifkontakt (12) oder Schleifbahnen (9, 10, 11) durch die Stellung des Funktionselements (5) bestimmt wird bzw. werden.

10. Erfassungseinrichtung nach Anspruch 9, **dadurch gekennzeichnet, dass** mindestens zwei, vorzugsweise genau zwei, Schleifbahnen (9, 10) den Signalausgang (S1, S2) der Erfassungseinrichtung (2) bilden, vorzugsweise, dass eine Schleifbahn (11) mit dem Referenzpotential (M), insbesondere Massepotential (M), beaufschlagt ist.

11. Kraftfahrzeugschloss mit einer Schlossmechanik (13), die in verschiedene Funktionszustände bringbar ist, und mit einer Erfassungseinrichtung (2) für die Erfassung von mechanischen Funktionszuständen nach einem der vorhergehenden Ansprüche.

12. Kraftfahrzeugschloss nach Anspruch 11, **dadurch gekennzeichnet, dass** die Erfassungseinrichtung (2) im montierten Zustand mindestens einem verstellbaren Funktionselement (5) des Kraftfahrzeugschlosses (1) zugeordnet ist und dass der logische Zustand der Erfassungseinrichtung (2) durch die Stellung des mindestens einen Funktionselements (5) bestimmt wird, vorzugsweise, dass die Schlossmechanik (13) und damit das Kraftfahrzeugschloss (1) in unterschiedliche Funktionszustände wie "verriegelt", "entriegelt", "diebstahlgesichert", "verriegelt-kindergesichert" und "entriegelt-kindergesichert" bringbar ist.

13. Kraftfahrzeugschloss nach Anspruch 12, **dadurch gekennzeichnet, dass** das Funktionselement (5), dem die Sensoranordnung (4) der Erfassungseinrichtung (2) zugeordnet ist, als Steuerwelle mit mindestens einem axialen Steuerabschnitt (5b) zum Ausleiten von Steuerbewegungen ausgestaltet ist.

14. Kraftfahrzeugschloss nach Anspruch 13, **dadurch gekennzeichnet, dass** die Sensoranordnung (4) als Schleifbahnanordnung (8), insbesondere als Schleifringanordnung (8), mit mindestens drei elektrisch voneinander getrennt ausgestalteten Schleifbahnen (9, 10, 11) und mit einem relativ zu den Schleifbahnen (9, 10, 11) verstellbaren Schleifkontakt (12) ausgestaltet ist, dass der Schleifkontakt (12) die Schleifbahnen (9, 10, 11) je nach Stellung elektrisch miteinander verbindet, vorzugsweise, dass die als Schleifringanordnung (8) ausgestaltete Schleifbahnanordnung (8) konzentrisch auf die Steuerwellenachse (5a) ausgerichtet ist.

15. Verfahren zur Erfassung von mechanischen Funktionszuständen eines Kraftfahrzeugschlosses (1) mittels einer Erfassungseinrichtung (2) nach einem der Ansprüche 1 bis 10, wobei die Erfassungseinrichtung (2) mindestens zwei binäre Signalausgänge (S1, S2) aufweist, die über die jeweils dort anliegenden elektrischen Potentiale einen logischen Zustand der Erfassungseinrichtung (2) definieren, wobei jeder Funktionszustand des Kraftfahrzeugschlosses (1) einen logischen Zustand der Erfassungseinrichtung (2) erzeugt,
**dadurch gekennzeichnet,**
**dass** der Funktionszustand des Kraftfahrzeugschlosses (1) basierend auf dem logischen Zustand der Signalausgänge (S1, S2) und dem elektrischen Widerstand zwischen vorbestimmten Signalausgängen (S1, S2) ermittelt wird.

## Claims

1. Detection device for detecting mechanical functional states of a motor vehicle lock (1), in which at least two binary signal outputs (S1, S2) are provided which define a logical state of the detection device (2) through the respective electrical potentials present there, in which, in the assembled state, each functional state of the motor vehicle lock (1) generates a logical state of the detection device (2), and in which a control arrangement (3) is provided which is coupled electrically with the signal outputs (S1, S2) and, on the basis of this coupling, determines the functional state of the motor vehicle lock (1),
**characterized in that**
in the assembled state, at least two functional states of the motor vehicle lock (1) generate one and the same logical state - multiple state - of the detection device (2), that these functional states are distinguishable **in that** the electrical resistance between the predetermined signal outputs (S1, S2) of the detection device (2) differs depending on the respective functional state of the motor vehicle lock (1), and that the control arrangement (3) determines the functional state of the motor vehicle lock (1) on the basis of the logical state of the signal outputs (S1, S2) and of the electrical resistance between the predetermined signal outputs (S1, S2).

2. Detection device according to Claim 1 **characterised in that** the electrical resistance between the two predetermined signal outputs (S1, S2) corresponds to an electrically conductive connection or tends to infinity, depending on the respective functional state.

3. Detection device according to Claim 1 or 2, **characterized in that** the detection device (2) comprises precisely two signal outputs (S1, S2), and that precisely one multiple state is provided, or that the detection device (2) comprises more than two signal outputs (S1, S2), and at least two multiple states are provided.

4. Detection device according to one of the previous claims, **characterized in that** the detection device (2) comprises a sensor arrangement (4) which makes the signal outputs (S1, S2) of the detection device (2) available.

5. Detection device according to Claim 4, **characterized in that** an electrical reference potential (M), in particular ground potential (M), is provided, and that the sensor arrangement (4) connects the reference potential (M) through to the signal outputs (S1, S2) to set a logical state, preferably that the sensor arrangement (4) in the assembled state connects the reference potential (M) through to the signal outputs (S1, S2) depending on the current functional state of the motor vehicle lock (1).

6. Detection device according to Claim 4 and, if relevant, in Claim 5, **characterized in that** the detection device (2), when in the assembled state, is associated with at least one adjustable functional element (5) of the motor vehicle lock (1), and that the logical state of the detection device (2) is determined by the position of the at least one functional element (5).

7. Detection device according to Claim 6, **characterized in that** the sensor arrangement (4) comprises at least two sensor switches (6, 7), in particular changeover switches (6, 7) which, in the assembled state, interact with the at least one functional element (5) of the motor vehicle lock (1), and whose switching states are determined by the position of the at least one functional element (5).

8. Detection device according to Claim 7, **characterized in that** the center contacts (6.0, 7.0) of the changeover switches (6, 7) each form one signal output (S1, S2), and that a first switch contact (6.1) of a first changeover switch (6) is connected to a first switch contact (7.1) of a second changeover switch (7), preferably that a second switch contact (6.2) of the first changeover switch (6) and a second switch contact (7.2) of the second changeover switch (7) is connected to a reference potential (M), in particular to ground potential (M), preferably that at least one of the changeover switches (6, 7) has a center position in which the center contact (7.0) is connected with a third switch contact (7.3), further preferably that the center contact (7.0) does not have the reference potential (M) applied to it when in the center position.

9. Detection device according to Claim 4 and, if relevant, according to one of Claims 5 to 8, **characterized in that** the sensor arrangement (4) is designed as a sliding track arrangement (8) with sliding tracks (9, 10, 11) designed to be electrically separate from one another, and with a sliding contact (12) which can be repositioned relative to the sliding tracks (9, 10, 11), and that the sliding contact (12) connects the sliding tracks (9, 10, 11) electrically depending on the position, preferably that the sliding contact (12) or the sliding tracks (9, 10, 11) interacts or interact with the at least one functional element (5) of the motor vehicle lock (1), and the position of the sliding contact (12) or of the sliding tracks (9, 10, 11) is determined through the position of the functional element (5).

10. Detection device according to Claim 9, **characterized in that** at least two, preferably precisely two, sliding tracks (9, 10) constitute the signal output (S1, S2) of the detection device (2), advantageously that the reference potential (M), in particular the ground potential (M) is applied to one sliding track (11).

11. Motor vehicle lock with a lock mechanism (13) which can be placed in different functional states, and with a detection device (2) for detecting mechanical functional states according to one of the previous claims.

12. Motor vehicle lock according to Claim 11, **characterized in that** the detection device (2) in the assembled state is associated with at least one adjustable functional element (5) of the motor vehicle lock (1), and that the logical state of the detection device (2) is determined by the position of the at least one functional element (5), preferably that the lock mechanism (13), and with that the motor vehicle lock (1), can be placed in different functional states such as "locked", "unlocked", "theft-protected", "locked and child-safe "and "unblocked and child-safe".

13. Motor vehicle lock according to Claim 12, **characterized in that** the functional element (5) which is associated with the sensor arrangement (4) of the detection device (2) is designed as a control shaft with at least one axial control section (5b) for routing control movements out.

14. Motor vehicle lock according to Claim 13, **characterized in that** the sensor arrangement (4) is designed as a sliding track arrangement (8), in particular as a slip ring arrangement (8), with at least three sliding tracks (9, 10, 11) designed to be electrically separate from one another, and with a sliding contact (12) which can be repositioned relative to the sliding tracks (9, 10, 11), that the sliding contact (12) connects the sliding tracks (9, 10, 11) electrically depending on the position, preferably that the sliding track arrangement (8) designed as a slip ring arrangement (8) is positioned concentrically on the control shaft (5a).

15. Method for detecting mechanical functional states of a motor vehicle lock (1) by means of a detection device (2) according to one of Claims 1 to 10, in which the detection device (2) comprises at least two binary signal outputs (S1, S2) which, through the electrical potentials respectively present, define a logical state of the detection device (2), in which each functional state of the motor vehicle lock (1) generates a logical state of the detection device (2),
**characterized in that**
the functional state of the motor vehicle lock (1) is determined on the basis of the logical state of the signal outputs (S1, S2) and of the electrical resistance between predetermined signal outputs (S1, S2).

## Revendications

1. Mécanisme de détection destiné à la détection d'états de fonctionnement mécaniques d'une serrure de véhicule à moteur (1), dans lequel au moins deux sorties de signaux (S1, S2) binaires sont prévues, lesquelles définissent un état logique du mécanisme de détection (2) par l'intermédiaire des potentiels électriques qui s'y trouvent respectivement ;
dans lequel chaque état de fonctionnement de la serrure de véhicule à moteur (1) génère, à l'état monté, un état logique du mécanisme de détection (2) ; et
dans lequel une disposition de commande (3) est prévue, laquelle est couplée de manière électrique aux sorties de signaux (S1, S2) et détermine l'état de fonctionnement de la serrure de véhicule à moteur (1) sur la base de cet accouplement,
**caractérisé en ce que**,
au moins deux états de fonctionnement de la serrure de véhicule à moteur (1) génèrent, à l'état monté, un seul et même état logique - appelé état multiple - du mécanisme de détection (2) ;
**caractérisé en ce que**,
ces états de fonctionnement peuvent être distingués en ce sens que la résistance électrique entre les sorties de signaux (S1, S2) prédéterminées du mécanisme de détection (2) est différente en fonction de l'état de fonctionnement respectif de la serrure de véhicule à moteur (1) ; et
**caractérisé en ce que**,
la disposition de commande (3) détermine l'état de fonctionnement de la serrure de véhicule à moteur (1) sur la base de l'état logique des sorties de signaux (S1, S2) et de la résistance électrique entre les sorties de signaux (S1, S2) prédéterminées.

2. Mécanisme de détection selon la revendication 1, **caractérisé en ce que** la résistance électrique entre les deux sorties de signaux (S1, S2) prédéterminées correspond à une connexion en conduction électrique en fonction de l'état de fonctionnement respectif ou tend vers l'infini.

3. Mécanisme de détection selon la revendication 1 ou 2. **caractérisé en ce que** le mécanisme de détection (2) présente exactement deux sorties de signaux (S1, S2) et **caractérisé en ce que**, exactement, un état multiple est prévu ou **caractérisé en ce que** le mécanisme de détection (2) présente plus de deux sorties de signaux (S1, S2) et **caractérisé en ce qu'**au moins deux états multiples sont prévus.

4. Mécanisme de détection selon l'une des revendications précédentes, **caractérisé en ce que** le mécanisme de détection (2) présente un dispositif de capteur (4) qui met à disposition les sorties de signaux (S1, S2) du mécanisme de détection (2).

5. Mécanisme de détection selon la revendication 4, **caractérisé en ce qu'**un potentiel électrique de référence (M) est prévu, en particulier un potentiel de masse (M), et **caractérisé en ce que** le dispositif de capteur (4) répartit le potentiel de référence (M) vers les sorties de signaux (S1, S2) en vue du réglage d'un état logique, et de préférence, **caractérisé en ce que** le dispositif de capteur (4) répartit, à l'état monté, le potentiel de référence (M) vers les sorties de signaux (S1, S2) en fonction de l'état de fonctionnement actuel de la serrure de véhicule à moteur (1).

6. Mécanisme de détection selon la revendication 4 et le cas échéant selon la revendication 5, **caractérisé en ce que** le mécanisme de détection (2) est associé, à l'état monté, à au moins un élément fonctionnel (5) de la serrure de véhicule à moteur (1), lequel élément fonctionnel (5) peut être ajusté, et **caractérisé en ce que** l'état logique du mécanisme de détection (2) est déterminé par la position de l'au moins un élément fonctionnel (5).

7. Mécanisme de détection selon la revendication 6, **caractérisé en ce que** le dispositif de capteur (4) présente au moins deux commutateurs de détection (6, 7), en particulier des commutateurs à bascule (6, 7) qui, à l'état monté, interagissent avec l'au moins un élément fonctionnel (5) de la serrure de véhicule à moteur (1) et leurs états de commutation sont déterminés par la position de l'au moins un élément fonctionnel (5).

8. Mécanisme de détection selon la revendication 7, **caractérisé en ce que** les contacts centraux (6.0, 7.0) des commutateurs à bascule (6, 7) forment respectivement une sortie de signaux (S1, S2) et le premier contact de commutation (6.1) d'un premier commutateur à bascule (6) est connecté avec un premier contact de commutation (7.1) d'un deuxième commutateur à bascule (7), et de préférence **caractérisé en ce qu'**un deuxième contact de commutation (6.2) du premier commutateur à bascule (6) et un deuxième contact de commutation (7.2) du deuxième commutateur à bascule (7) sont connectés avec un potentiel de référence (M), en particulier avec un potentiel de masse (M), et de préférence, **caractérisé en ce qu'**au moins l'un des commutateurs à bascule (6, 7) présente une position centrale, dans laquelle le contact central (7.0) est connecté avec un troisième contact de commutation (7.3), et caractérisé en outre de préférence **en ce que** le contact central (7.0) n'est pas exposé au potentiel de référence (M) dans la position centrale.

9. Mécanisme de détection selon la revendication 4 et le cas échéant selon l'une des revendications 5 à 8, **caractérisé en ce que** le dispositif de capteur (4) est configuré sous la forme d'une disposition de trajectoires de glissement (8) avec des trajectoires de glissement (9, 10, 11) qui sont configurées de manière à être séparées électriquement les unes des autres et avec un contact coulissant (12) qui peut être ajusté par rapport aux trajectoires de glissement (9, 10, 11) et **caractérisé en ce que** le contact coulissant (12) connecte électriquement les trajectoires de glissement (9, 10, 11) les unes aux autres en fonction de la position, de préférence, **caractérisé en ce que** le contact coulissant (12) ou les trajectoires de glissement (9, 10, 11) interagit, respectivement interagissent avec l'au moins un élément fonctionnel (5) de la serrure de véhicule à moteur (1) et la position du contact coulissant (12) ou des trajectoires de glissement (9, 10, 11) est, respectivement sont déterminé(s) par la position de l'élément fonctionnel (5).

10. Mécanisme de détection selon la revendication 9, caractérisé en ce que'au moins deux, de préférence exactement deux, trajectoires de glissement (9, 10) forment la sortie de signaux (S1, S2) du mécanisme de détection (2), de préférence **caractérisé en ce qu'**une trajectoire de glissement (11) est exposée au potentiel de référence (M), en particulier au potentiel de masse (M).

11. Serrure de véhicule à moteur avec un mécanisme de serrure (13), lequel peut être positionné dans divers états de fonctionnement, et avec un mécanisme de détection (2) destiné à la détection d'états de fonctionnement mécaniques selon l'une des revendications précédentes.

12. Serrure de véhicule à moteur selon la revendication 11, **caractérisée en ce que** le mécanisme de détection (2) est associé, à l'état monté, à au moins un élément fonctionnel (5) pouvant être ajusté de la serrure de véhicule à moteur (1), et **en ce que** l'état logique du mécanisme de détection (2) est déterminé par la position de l'au moins un élément fonctionnel (5), de préférence **en ce que** le mécanisme de serrure (13) et, de ce fait, la serrure de véhicule à moteur (1) peuvent être positionnés dans différents états de fonctionnement tels que par exemple : « verrouillé », « déverrouillé », « verrouillage de protection contre le vol », « verrouillage de protection pour les enfants » et « déverrouillage de protection pour les enfants ».

13. Serrure de véhicule à moteur selon la revendication 12, **caractérisée en ce que** l'élément fonctionnel (5), auquel est associé le dispositif de capteur (4) du mécanisme de détection (2), est configuré sous la forme d'un arbre de commande avec au moins une section de commande (5b) axiale destinée à la redirection des mouvements de commande.

14. Serrure de véhicule à moteur selon la revendication 13, **caractérisée en ce que** le dispositif de capteur (4) est configuré sous la forme d'une disposition de trajectoires de glissement (8), en particulier sous la forme d'un dispositif à bague collectrice (8), avec au moins trois trajectoires de glissement (9, 10, 11) qui sont configurées de manière à être séparées électriquement les unes des autres et avec un contact coulissant (12) qui peut être ajusté par rapport aux trajectoires de glissement (9, 10, 11), **caractérisée en ce que** le contact coulissant (12) connecte électriquement les trajectoires de glissement (9, 10, 11) les unes aux autres en fonction de la position, de préférence **caractérisée en ce que**, la disposition de trajectoires de glissement (8), laquelle est configurée sous la forme d'un dispositif à bague collectrice (8), est alignée de manière concentrique sur l'axe de l'arbre de commande (5a).

15. Procédé destiné à la détection des états de fonctionnement mécaniques d'une serrure de véhicule à moteur (1) au moyen d'un mécanisme de détection (2) selon l'une des revendications 1 à 10,
dans lequel le mécanisme de détection (2) présente au moins deux sorties de signaux (S1, S2) binaires, lesquelles définissent un état logique du mécanisme de détection (2) par l'intermédiaire des potentiels électriques qui s'y trouvent respectivement ;
dans lequel chaque état de fonctionnement de la serrure de véhicule à moteur (1) génère un état logique du mécanisme de détection (2),
**caractérisé en ce que**,
l'état de fonctionnement de la serrure de véhicule à moteur (1) est déterminé sur la base de l'état logique des sorties de signaux (S1, S2) et de à résistance électrique entre des sorties de signaux (S1, S2) prédéterminées.
